# FASCICULE DE BREVET EUROPEEN

(11) **EP 2 263 970 B1**
(45) Date de publication et mention de la délivrance du brevet: **29.08.2012**
(21) Numéro de dépôt: 10165006.7
(22) Date de dépôt: 04.06.2010
(51) Int. Cl.: B81C 99/00

(54) **Procédé d'excitation d'un élément mobile d'une microstructure**
Verfahren zur Aktivierung eines beweglichen Elements einer Mikrostruktur
Method for exciting a mobile element of a microstructure

(30) Priorité: 18.06.2009 FR 0902954
(43) Date de publication de la demande: 22.12.2010
(73) Titulaire: Commissariat à l'Énergie Atomique et aux Énergies Alternatives, 75015 Paris (FR)
(72) Inventeur: Blanc, Henri, 38000, GRENOBLE (FR)
(74) Mandataire: Guérin, Jean-Philippe

(56) Documents cités:
- DE-A1-102007 016 735

## Description

L'invention concerne les capteurs formés dans des microstructures ou des nanostructures, et en particulier les tests de validation du fonctionnement de tels capteurs.

Un nombre croissant de produits de la vie courante intègre des puces munies de microsystèmes électromécaniques (MEMS) ou de nanosystèmes électromécaniques (NEMS). Les accéléromètres ou les gyromètres incluent notamment des capteurs MEMS inertiels.

Avec l'amélioration des procédés de gravure de silicium et la recherche d'augmentation de la densité des circuits, des puces intégrant des nanosystèmes électromécaniques connaissent de nombreux développements. Un nanosystème peut notamment inclure un élément sensible résonant de capteur. L'élément sensible est fréquemment intégré dans une architecture CMOS et est généralement associé à une électrode d'excitation et à une électrode de mesure. L'élément sensible est mobile selon un degré de liberté pour lequel il présente une fréquence de résonance. L'élément sensible présente une de ses dimensions typiquement comprise entre 50 et 500nm. Cette réduction de l'échelle des éléments sensibles est supposée permettre d'augmenter leur densité d'intégration dans des wafers ou plaquettes telles que des tranches de silicium, ainsi que leurs performances, et ainsi de diminuer le coût unitaire de chaque puce. L'intégrité et les propriétés de l'élément sensible doivent cependant être testées au cours du procédé de fabrication. Un simple contrôle visuel au microscope électronique à balayage s'avère insuffisant pour déterminer si l'élément sensible est fonctionnel. Les tests visent ainsi à déterminer la fréquence de résonance et le facteur de qualité de l'élément sensible. Le test comprend d'une part l'excitation de l'élément sensible et d'autre part des mesures du mouvement de l'élément sensible.

Une technique connue pour exciter des éléments sensibles consiste à utiliser un équipement de test électrique muni de pointes spéciales.

Cette technique est la seule utilisée pour les capteurs formés en approche descendante (aussi appelée top down en langue anglaise) sur une tranche de silicium entière, c'est-à-dire avant la séparation des différentes puces. Chaque électrode d'excitation est munie d'un plot de contact contre lequel une pointe de l'équipement de test vient en contact électrique. Les pointes appliquent une tension alternative sur les plots pour générer un mouvement des éléments sensibles selon leur degré de liberté. Cependant, chaque plot de contact occupe une surface approximativement 20 à 100 fois supérieure à la surface d'un élément sensible. Une diminution des dimensions des éléments sensibles ne permet alors d'augmenter la densité d'intégration que dans une faible mesure, les éléments limitants devenant alors les plots de contact.

Les plots de contact peuvent être réutilisés pour la connexion à un circuit électronique associé. Dès lors, les plots de contact sont fonctionnels durant le cycle de vie de la puce. Cependant, dans des technologies où l'électronique est réalisée dans la même tranche de silicium que les éléments sensibles (technologies dites in IC en langue anglaise), ces plots ne présentent plus d'utilité fonctionnelle durant le cycle de vie de la puce. De plus, la formation de tels plots nécessite de nombreuses étapes technologiques, engendrant un surcoût et un accroissement de la durée du processus de fabrication. Le nombre d'étapes technologiques pour la formation des plots de contact peut même être supérieur à celui nécessaire à la formation des éléments sensibles eux-mêmes. Les plots de contact sont usuellement formés au début du processus de fabrication des puces. La formation des plots de contact induit cependant de nombreux aléas pour la réalisation ultérieure plus délicate des éléments sensibles, ce qui accroît le taux de rebuts. La présence du métal dans les plots de contact est également limitante pour la suite du processus de fabrication. Les plots de contact sont eux-mêmes une source non négligeable de parasites lors du test : ces plots peuvent ainsi induire des capacités parasites dont l'ordre de grandeur peut être plusieurs centaines de fois supérieur à la valeur de capacité de détection d'un élément sensible capacitif.

Dans des implantations en même tranche (in IC), les éléments sensibles peuvent être dépourvus de plots de contact dédiés. Des pistes de connexion du circuit intégré sont alors utilisées pour exciter les éléments sensibles. Une telle architecture ne permet alors pas de tester les éléments sensibles indépendamment du circuit intégré. Il est alors impossible de séparer des causes de dysfonctionnement ou de vérifier l'incidence du circuit intégré sur le fonctionnement des éléments sensibles.

Pour la formation de capteurs en approche ascendante (également appelée bottom up en langue anglaise), les problèmes rencontrés lors des phases de test sont encore plus gênants. Les éléments sensibles réalisés en approche ascendante sont généralement d'une taille plus réduite et leurs performances sont plus délicates à mesurer. Dans des réalisations expérimentales, de tels éléments sensibles sont réalisés avant la formation de plots de contact. En pratique, il s'avère presque impossible de former ensuite les plots de contact sans détruire les éléments sensibles, du fait de la fragilité de ces derniers. Les plots de contact induisent en outre des capacités parasites dont l'ordre de grandeur est encore plus gênant que pour des capteurs réalisés en approche descendante.

Les techniques de mesure optique des éléments sensibles excités s'avèrent inadaptées pour des microstructures et a fortiori pour des nanostructures. Les faisceaux optiques présentent en effet une dimension minimale d'environ 5 micromètres, ce qui peut correspondre à plusieurs fois la taille de l'élément sensible en mouvement.

Un certain nombre d'études proposent ainsi de réaliser, au moyen d'un microscope électronique à balayage, une mesure de l'élément sensible excité. De tels microscopes émettent un faisceau d'électrons dont la taille peut être abaissée jusqu'à 5 nm. La publication de Mrs Gilles Megherbi, Raynaud, Parrain, Mathias, Leroux et Bosseboeuf du 3 Décembre 2007 intitulée « scanning electron microscopy for vacuum quality factor measurement of small-size MEMS resonators » décrit notamment différentes méthodes de mesure mises en oeuvre dans un microscope électronique à balayage. Le capteur excité est soumis à un faisceau d'électrons émis par le microscope. L'impact de ce faisceau induit une émission d'électrons secondaires par le capteur. Ces électrons secondaires sont reçus sur un détecteur et analysés de façon à identifier un déplacement du capteur excité. Des paramètres du capteur tels que l'amplitude de son déplacement ou la fréquence de résonance de l'élément sensible pourront être déterminés. Une telle méthode de mesure présente cependant des inconvénients.

De plus, la plupart des méthodes de test ne peuvent être mises en oeuvre qu'à une étape très tardive du processus de fabrication, l'excitation d'un élément sensible impliquant par exemple la connexion préalable des circuits électroniques fonctionnels dans des implantations en même tranche. Ainsi, la plupart des étapes du procédé de fabrication doivent être exécutées avant de pouvoir constater un défaut touchant les premières étapes. Par ailleurs, il est difficile de déterminer systématiquement la fiabilité d'une excitation par contact électrique.

Un autre procédé d'excitation et de test d'une structure micromécanique est décrit dans la publication DE 10 2007 016 735 A1. Ce procédé comprend l'excitation d'un élément mobile par un champ magnétique.

L'invention vise à résoudre un ou plusieurs de ces inconvénients. L'invention concerne ainsi un procédé d'excitation d'un élément résonant d'une microstructure, cet élément étant mobile selon un degré de liberté, le procédé comprenant une étape d'application d'un faisceau de particules chargées sur ladite microstructure, le faisceau étant configuré de façon à entraîner l'élément selon un mouvement alternatif selon son degré de liberté.

Selon une variante, le faisceau de particules est appliqué sur ledit élément pour l'entraîner par effet mécanique selon ledit mouvement alternatif.

Selon encore une variante, le faisceau de particules est appliqué sur ledit élément selon une incidence présentant une composante parallèle audit degré de liberté.

Selon une autre variante, l'angle du faisceau est inférieur à 45° par rapport audit degré de liberté.

Selon encore une autre variante, la microstructure comprend en outre un dispositif d'excitation conducteur, disposé à proximité dudit élément résonant, le faisceau de particules étant appliqué sur le dispositif d'excitation de façon à entraîner l'élément résonant selon ledit mouvement alternatif, par effet capacitif entre l'élément résonant et le dispositif d'excitation.

Selon une variante, le dispositif d'excitation conducteur comprend une électrode d'excitation en regard de l'élément et un organe conducteur connecté électriquement à l'électrode d'excitation, le faisceau de particules étant appliqué sur ledit organe conducteur.

Selon encore une variante, le dispositif d'excitation comprend un circuit électrique raccordant l'électrode d'excitation à la masse et présentant une impédance électrique permettant l'entraînement de l'élément résonant à sa fréquence de résonance.

Selon une autre variante, la microstructure est disposée dans une enceinte sous vide durant l'excitation de l'élément.

Selon encore une autre variante, ledit faisceau présente des propriétés variables temporellement de façon à entraîner l'élément selon ledit mouvement alternatif.

Selon une variante, les propriétés du faisceau varient temporellement soit en déplaçant le faisceau par rapport à la microstructure de façon à ce qu'elle reçoive alternativement le faisceau de particules soit en maintenant le faisceau fixe par rapport à la microstructure et en appliquant un faisceau d'intensité variable.

Selon encore une variante, les propriétés variables du faisceau comprennent la vitesse des particules chargées, l'angle du faisceau par rapport au degré de liberté ou l'amplitude du faisceau.

Selon une autre variante, les propriétés du faisceau varient temporellement avec une fréquence variable incluse dans une plage de fréquences incluant la fréquence de résonance supposée du mouvement de l'élément résonant selon son degré de liberté.

Selon encore une autre variante, une des dimensions dudit élément est submicronique

L'invention concerne également un procédé de test d'un élément d'une microstructure, comprenant l'excitation dudit élément selon le procédé d'excitation décrit ci-dessus, et comprenant en outre la mesure de la fréquence de résonance dudit élément selon son degré de liberté.

Selon une variante, la mesure de la fréquence de résonance comprend :
- l'application d'un autre faisceau de particules chargées sur ledit élément, lesdits faisceaux présentant des angles d'incidence distincts ;
- la détection de particules chargées émises par ledit élément lors de l'application de l'autre faisceau.

Selon encore une variante, ladite microstructure est ménagée dans une plaquette incluant plusieurs microstructures similaires et dans lequel plusieurs desdites microstructures sont testées séquentiellement.

Selon une autre variante, lequel lesdites microstructures sont testées séquentiellement en maintenant ladite plaquette dans une enceinte sous vide.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue de dessus d'un exemple de microstructure à tester ;
- la figure 2 est une vue de détail de la microstructure de la figure 1 ;
- la figure 3 est une vue en coupe de la microstructure de la figure 1 ;
- la figure 4 est une vue en coupe de la microstructure de la figure 1 durant un procédé de test selon un mode de réalisation de l'invention ;
- la figure 5 est une vue en coupe d'une microstructure présentant un autre degré de liberté ;
- la figure 6 est une vue en coupe de la microstructure de la figure 5 durant un procédé de test selon un mode de réalisation de l'invention ;
- la figure 7 est une vue de dessus d'une variante de microstructure destinée à être testée ;
- la figure 8 est une représentation schématique d'un dispositif destiné à mettre en oeuvre des tests de microstructures.

Usuellement, une observation au microscope électronique à balayage génère une charge électrostatique induisant une précontrainte d'un élément résonant néfaste aux résultats des tests. De façon surprenante, l'invention propose d'exciter l'élément résonant de la microstructure avec un faisceau de particules chargées. Ce faisceau de particules est appliqué sur l'élément résonant de façon à l'entraîner selon un mouvement alternatif selon un degré de liberté. Le faisceau pourra par exemple être appliqué alternativement sur l'élément en déplaçant le faisceau par rapport à l'élément (par balayage de l'élément) ou en modulant l'émission de particules du faisceau.

Un tel procédé permet d'exciter l'élément résonant sans contact électrique avec des plots de contact externes, et ainsi de réduire la taille occupée par la microstructure. L'introduction de capacités parasites est très sérieusement réduite et la sensibilité de l'excitation à ces parasites est très fortement réduite. L'excitation est également indépendante de tout circuit fonctionnel accolé à l'élément résonant. Par ailleurs, l'invention permet éventuellement d'exciter l'élément résonant selon deux procédés distincts pour croiser les résultats des tests. Des faisceaux de particules chargées peuvent être réalisés avec des dimensions suffisamment fines pour être focalisés en un emplacement approprié de l'élément résonant.

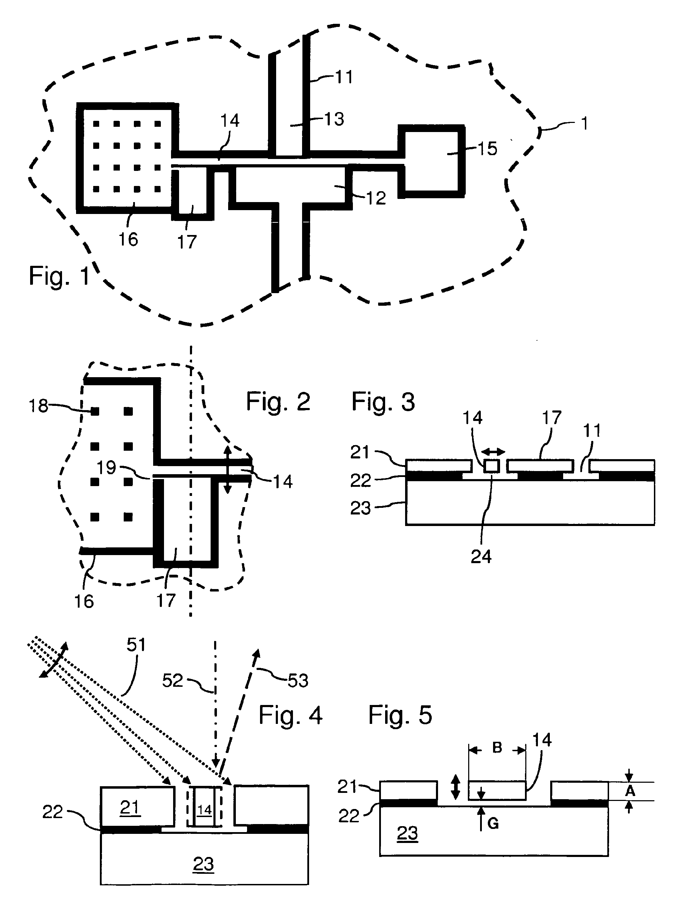

La figure 1 est une vue de dessus d'un exemple de microstructure 1 ménagée dans une tranche de silicium. Cette microstructure 1 comprend un capteur. Le capteur comprend différents composants délimités par une gravure 11 de la tranche de silicium. Le capteur comprend notamment un élément résonant 14. L'élément résonant 14 est encastré à ses deux extrémités respectivement dans une masse mobile 16 et dans un bloc 15. L'élément résonant 14 présente une forme de lame dont l'axe joint la masse mobile 16 au bloc 15. Le capteur comprend une électrode d'excitation 13 et une électrode de mesure 12 disposées de part et d'autre de la partie médiane de l'élément résonant 14. L'élément résonant 14 est séparé des électrodes 12 et 13 par un entrefer défini par la gravure 11. Le capteur comprend également un bloc 17 auquel la masse mobile 16 est reliée par l'intermédiaire d'une articulation flexible 19.

Comme illustré à la figure 3, le capteur peut être implanté dans une tranche de silicium. La tranche de silicium illustrée est réalisée en technologie silicium sur isolant. La tranche de silicium comprend une couche substrat de silicium 23 sur laquelle une couche isolante 22 en SiO₂ est ménagée. Une couche additionnelle de silicium 21 est ménagée sur la couche isolante 22. La gravure 11 traverse la couche de silicium 21 et la couche isolante 22. Ainsi, la gravure 11 permet d'isoler électriquement différents composants du capteur. La gravure 11 peut être réalisée de façon connue en soi par un procédé de photolithographie.

Afin de rendre certains composants ménagés dans la couche de silicium 21 mobiles par rapport au substrat 23, des évidements 24 sont créés sous ces composants. Ainsi, la couche d'isolant 22 est retirée entre l'élément résonant 14 et le substrat 23, et entre la masse mobile 16 et le substrat 23. L'élément 14 et la masse mobile 16 sont ainsi mobiles dans le plan de la couche de silicium 21. Les évidements 24 peuvent être formés de façon connue en soi par une gravure chimique isotrope. De façon connue en soi, la masse mobile 16 présente des orifices 18 traversant la couche de silicium 21. Ainsi, la couche isolante 22 peut être retirée sous l'ensemble de la masse mobile 16 lors de l'attaque chimique isotrope, malgré sa section plus importante dans le plan de la couche 21. A contrario, les blocs 15 et 17, ainsi que les électrodes 12 et 13 sont encastrées dans le substrat 23 par l'intermédiaire de la couche isolante 22.

L'élément résonant 14 et la masse mobile 16 sont mobiles dans le plan de la tranche de silicium. La partie médiane de l'élément 14 est mobile en translation perpendiculairement à son axe, comme illustré par les flèches aux figures 2 et 3. Les dimensions et le matériau de l'élément résonant 14 ainsi que la masse et les efforts appliqués sur la masse mobile 16 définissent une fréquence de résonance de l'élément 14 selon ce degré de liberté. À cette fréquence de résonance, l'amplitude du déplacement de l'élément résonant 14 est maximale pour une énergie d'excitation donnée fournie par l'électrode 13.

En fonctionnement, l'électrode d'excitation 13 est alimentée par une tension alternative par l'intermédiaire de contacts métalliques, afin d'induire un mouvement alternatif de l'élément 14. L'élément 14 est en couplage capacitif avec l'électrode de mesure 12. Un circuit non illustré permet de mesurer la fréquence et l'amplitude de la vibration de l'élément 14 lorsque la microstructure 1 est en fonctionnement, de façon connue en soi. Cette fréquence et cette amplitude varient en fonction du mouvement de la masse mobile 16. La microstructure 1 illustrée est à un stade intermédiaire de son procédé de fabrication. La microstructure est ainsi dépourvue de contacts métalliques pour les électrodes 12 et 13.

La figure 4 représente un procédé de test de la microstructure. Un faisceau de particules chargées, par exemple un faisceau d'électrons 51 est appliqué sur l'élément 14 dans une enceinte sous vide. Le faisceau d'électrons 51 génère une pression sur l'élément 14. La pression exercée présente une composante parallèle au degré de liberté de l'élément 14. La densité du faisceau 51 et la vitesse des électrons seront fixées à un niveau suffisant pour induire un mouvement de l'élément 14. Le faisceau 51 est ainsi configuré pour exercer une pression variable selon le degré de liberté de l'élément 14. On peut ainsi, générer un mouvement alternatif de l'élément 14 par l'application de façon séquentielle du faisceau 51 sur l'élément. Dans l'exemple illustré, l'application séquentielle du faisceau est obtenue par déflexion de l'angle du faisceau 51 par rapport au degré de liberté. La fréquence de cette déflexion correspond à la fréquence à laquelle on souhaite exciter l'élément 14. La pression exercée sur l'élément 14 selon le degré de liberté est donc variable.

Indépendamment , Comme illustré à la figure 4, le faisceau 51 peut être configuré pour être appliqué sur la ou les faces latérales de l'élément 14et/ou sur la face supérieure de l'élément 14.

Le faisceau 51 est avantageusement appliqué avec un angle aussi réduit que possible par rapport à la direction de déplacement de l'élément 14, afin de favoriser son excitation. Avantageusement, cet angle est inférieur à 45°. Idéalement, le faisceau 51 devrait être colinéaire à la direction de déplacement de l'élément 14.

Bien que l'exemple illustré utilise une variation de l'angle du faisceau 51 pour induire un mouvement de l'élément 14, d'autres paramètres du faisceau 51 peuvent être variés temporellement afin d'induire ce mouvement.

De façon générale, on pourra envisager d'une part un déplacement du faisceau 51 par rapport à l'élément 14, pour solliciter ou non au moins une face de l'élément 14, le faisceau 51 émettant de préférence de façon continue. On pourra également envisager d'autre part un faisceau 51 fixe par rapport à l'élément 14, le faisceau présentant une émission (autrement dit une intensité) variable pouvant même être nulle. On peut notamment appliquer un faisceau haché de position fixe 51 sur au moins une face de l'élément 14. Le hachage (ou variation d'intensité ) sera alors réalisé à la fréquence d'excitation souhaitée.

La fréquence d'excitation de l'élément 14 pourra notamment être modulée sur une plage de fréquences prédéfinie, incluant la fréquence de résonance supposée de l'élément 14. En excitant l'élément 14 sur cette plage de fréquences, on va pouvoir déterminer s'il est fonctionnel et déterminer le pic de résonance de son déplacement selon son degré de liberté.

Le faisceau 51 exerçant un effort mécanique sur l'élément 14, l'excitation de l'élément 14 ne nécessite pas d'alimentation électrique de la microstructure 1. La mesure de la fréquence de résonance de l'élément 14 ne nécessite que son intégrité mécanique et ne fait pas appel aux connexions électriques du capteur. Ce procédé d'excitation peut ainsi être réalisé à un stade très précoce de la fabrication des microstructures, notamment avant la formation des contacts électriques métalliques. Une éventuelle défaillance du processus de photolithographie ou de gravure chimique peut donc être décelée très tôt, avant de soumettre inutilement la tranche de silicium défaillante à la suite des étapes technologiques.

Avantageusement, un faisceau de détection 52 est appliqué sur l'élément 14 selon une orientation différente de celle du faisceau 51. Le faisceau 52 permet d'induire une émission d'un faisceau par exemple d'électrons secondaires 53 dont les propriétés varient en fonction de la position de l'élément 14. Durant son déplacement, le faisceau 52 touche ou non alternativement l'élément 14. En fonction de la présence ou non de l'élément 14 sous le faisceau 52, l'élément 14 va alternativement générer ou non le faisceau d'électrons secondaires 53. Cette alternance pourra également être mesurée par un détecteur, de façon connue en soi.

Le faisceau de détection 52 sera appliqué de façon optimale selon une direction perpendiculaire au degré de liberté de l'élément 14 afin de générer un plus grand contraste entre la réflexion par l'élément 14 et la diffusion ou réflexion par un autre composant. Le faisceau de détection 52 est de préférence appliqué au niveau de la limite au repos entre l'élément 14 et l'entrefer, afin d'optimiser la variation du signal de détection. La dissociation du faisceau d'excitation 51 et du faisceau de détection 52 permet ainsi d'optimiser ces faisceaux. Le faisceau d'excitation 51 doit notamment permettre d'entraîner l'élément 14 en induisant un minimum de perturbations sur le faisceau 53 généré par le faisceau 52. Le faisceau de détection 52 favorisera l'obtention d'un faisceau 53 présentant un rapport signal/bruit maximal.

Afin de faciliter la discrimination d'électrons secondaires générés par les faisceaux 51 et 52, ces faisceaux présenteront avantageusement des propriétés distinctes, telles que leur densité ou la vitesse des électrons émis. On peut également envisager de combiner un faisceau d'ions avec un faisceau d'électrons pour faciliter la discrimination des faisceaux 51 et 52.

Bien que l'on ait décrit une détection du mouvement de l'élément 14 basée sur un faisceau d'électrons secondaires, on peut également envisager de réaliser une détection électrique en utilisant l'électrode de mesure 12, lorsque le test est effectué à un stade suffisamment tardif du processus de fabrication. Une telle détection permet d'effectuer un test de la détection électrique sans excitation électrique. La détection électrique peut ainsi être caractérisée par un actionnement exclusivement mécanique, sans subir les perturbations d'une excitation électrique.

Un tel procédé de test s'avère particulièrement avantageux pour tester la tranche de silicium entière sans contact avec la microstructure, avant la séparation des différentes puces. Le procédé de test peut être effectué systématiquement sur chacune des microstructures, ou selon un échantillonnage statistique. Pour un échantillonnage statistique, on pourra mettre au rebut les microstructures testées si le test de celles-ci présente un risque destructif. Pour un test en tranche entière systématique, quel que soit le stade du processus de fabrication auquel il est réalisé, le test permet de trier les microstructures avant leur découpe et la réalisation des étapes ultérieures, ce qui constitue un gain non négligeable sur le processus de fabrication.

Les dimensions et propriétés de l'élément de la figure 4 peuvent être les suivantes : un entrefer entre l'élément 14 et les électrodes 12 et 13 de 100nm, une largeur de l'élément 14 comprise entre 50 et 2000nm selon le degré de liberté, et une épaisseur de l'élément 14 (dimension selon la normale au substrat 23) comprise entre 160nm et 4000nm. La fréquence de résonance de l'élément pourra typiquement être comprise entre 50 kHz et 1 GHz.

La figure 5 est une vue en coupe d'un autre type de capteur de microstructure implanté dans une tranche de silicium. Comme dans l'exemple de la figure 3, la tranche de silicium comprend une couche substrat de silicium 23 sur laquelle une couche isolante 22 en SiO₂ est ménagée. Une couche additionnelle de silicium 21 est ménagée sur la couche isolante 22. La gravure 11 traverse la couche de silicium 21 et la couche isolante 22. Le capteur inclut un élément vibrant 14 dont le degré de liberté est normal au plan du substrat de silicium 23.

Un évidement 24 est créé sous l'élément résonant 14. L'élément 14 est mobile perpendiculairement au plan de la couche de silicium 21. L'élément 14 peut être encastré par une de ses extrémités et présenter une autre extrémité libre. La fréquence de résonance nominale de l'élément 14 selon son degré de liberté est définie de façon connue en soi.

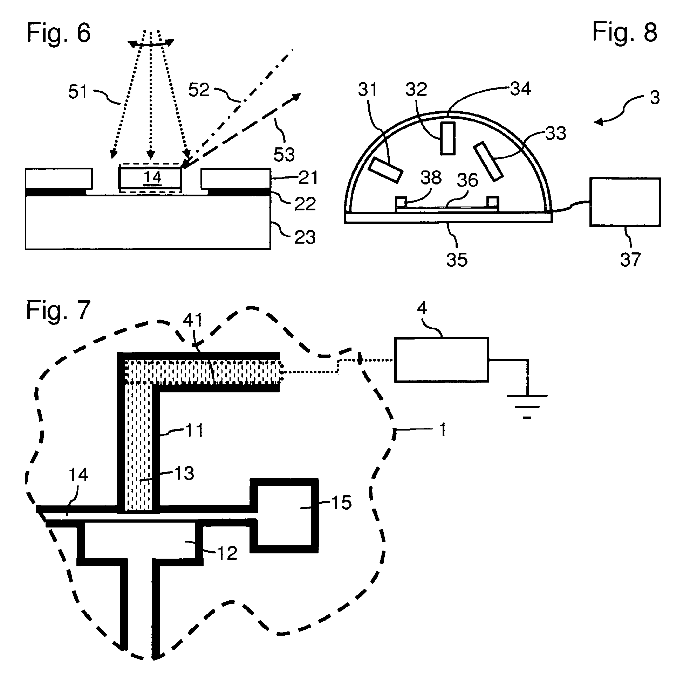

Les dimensions et propriétés de l'élément de la figure 6 peuvent être les suivantes : un entrefer (G sur la figure) entre l'élément 14 et le substrat 23 de 100nm, une épaisseur de l'élément 14 (A sur la figure) comprise entre 50 et 2000nm selon le degré de liberté, et une largeur de l'élément 14 (B sur la figure) comprise entre 160nm et 4000nm. La fréquence de résonance de l'élément pourra typiquement être comprise entre 50 kHz et 1 GHz.

La figure 6 représente un procédé de test de cette microstructure. Un faisceau d'électrons 51 est appliqué sur l'élément 14 dans une enceinte sous vide. Le faisceau d'électrons 51 génère une pression sur la face supérieure de l'élément 14. La pression exercée présente une composante parallèle au degré de liberté de l'élément 14. Par l'application du faisceau 51 avec des propriétés variant temporellement, un mouvement alternatif de l'élément 14 est généré. Dans l'exemple illustré, l'angle du faisceau 51 par rapport au degré de liberté est modulé de façon alternative. Comme illustré à la figure 6, le faisceau 51 peut être configuré pour être appliqué sur la face supérieure de l'élément 14, puis de part et d'autre de l'élément 14. La pression sur l'élément 14 selon le degré de liberté est ainsi variable. Le faisceau 51 est avantageusement appliqué selon la normale au plan de la couche de silicium 21. L'angle du faisceau 51 est légèrement varié par rapport à la normale au plan durant l'excitation.

Un faisceau de détection 52 est appliqué sur l'élément 14 selon une orientation différente de celle du faisceau 51. Le faisceau 52 permet d'induire une émission d'un faisceau d'électrons secondaires 53. En fonction de la position de l'élément 14, l'angle du faisceau 53 peut varier, ce qui peut être mesuré par un détecteur. Durant son déplacement, le faisceau 52 peut également alternativement toucher ou non l'élément 14. En fonction de la position de l'élément 14 par rapport au faisceau 52, l'élément 14 va modifier la génération du faisceau d'électrons secondaires 53.

Bien que le matériau semi-conducteur décrit dans les exemples précédents soit du silicium, l'invention peut également être réalisée dans des tranches incluant pour l'essentiel un autre type de matériau, par exemple un autre matériau semi-conducteur

La figure 7 représente en variante une microstructure configurée pour réaliser de façon indirecte une excitation de l'élément résonant 14 par le faisceau de particules ; cette variante permet notamment de limiter d'éventuels risques de détérioration lors de l'excitation.

En l'occurrence, le faisceau d'excitation 51 est appliqué sur une partie 41 du contact métallique de l'électrode d'excitation 13, ce contact métallique et cette électrode 13 forment un dispositif d'excitation intermédiaire. Dans ce mode de réalisation, l'élément 14 est déplacé non pas par une pression exercée par le faisceau 51 mais par effet capacitif entre l'électrode 13 et l'élément résonant 14. Lors de l'application du faisceau 51 sur la partie 41 du contact métallique, des charges sont transmises à la partie 41. L'électrode d'excitation 13 accumule alternativement ces charges pour générer un effet capacitif avec l'élément résonant 14. Un circuit résonant 4 raccorde le contact métallique de l'électrode d'excitation 13 à la masse. La fréquence de résonance du circuit 4 est adaptée à la fréquence de résonance mécanique de l'élément 14. Le circuit 4 forme un circuit passe-bande autour de sa fréquence de résonance. La bande passante et la pente de d'atténuation du circuit 4 seront déterminées de façon appropriée en fonction des propriétés du capteur à tester. Lorsque les propriétés du faisceau 51 varient à une fréquence approchant la fréquence de résonance du circuit 4, ce circuit 4 présente une impédance élevée. Le potentiel de l'électrode d'excitation 13 varie pour induire un déplacement alternatif de l'élément 14. Lorsque les propriétés du faisceau 51 varient à une fréquence s'éloignant de la fréquence de résonance du circuit 4, ce circuit 4 forme un court-circuit à la masse. L'électrode d'excitation 13 n'induit alors pas de déplacement de l'élément 14. Le faisceau 51 pourra par exemple induire une excitation alternative de l'élément résonant 14 soit par balayage alternatif du faisceau 51 sur la partie 41, soit par modulation de son intensité.

Ce mode de réalisation permet d'exciter l'élément 14 électriquement sans nécessiter de plots de contacts. La surface occupée par la microstructure 1 est ainsi réduite. La surface occupée par le contact métallique de l'électrode d'excitation 13 est en effet très inférieure à la surface d'un contact pour pointe d'alimentation de test. Par ailleurs, tout en réalisant une excitation électrique de l'élément 14, on peut fortement limiter les capacités parasites du fait de l'absence de plot d'excitation. De plus, le circuit 4 permet en outre de réaliser un filtrage passif des bruits au niveau de l'électrode d'excitation 13. Une telle excitation pourra également être effectuée sur une tranche entière de silicium. Une telle excitation pourra être combinée à un faisceau de détection tel que détaillé auparavant. Les interférences entre le faisceau d'excitation et le faisceau de détection sont alors réduites.

Le circuit 4 pourra être déconnecté de l'électrode d'excitation 13 pour l'utilisation fonctionnelle du capteur. Le fonctionnement du capteur ne sera ainsi pas parasité par le circuit 4. La déconnexion pourra être réalisée par tout moyen approprié, notamment par rupture d'un fusible, par coupure d'un contact au laser ou par un faisceau de particules, ou alors par blocage d'un transistor d'accès.

La figure 8 représente schématiquement un dispositif 3 de test de microstructures. Le dispositif 3 comprend un générateur 31 d'un faisceau d'électrons destiné à l'excitation de microstructures. Le dispositif 3 comprend un générateur 32 d'un faisceau d'électrons destiné à la détection des mouvements de l'élément 14. Le dispositif comprend également un détecteur d'électrons secondaires 33. Les générateurs 31 et 32 ainsi que le détecteur 33 surplombent un plateau 35. Les générateurs 31 et 32, ainsi que le détecteur 33 sont mobiles en translation par rapport au plateau 35. Le générateur 31 est mobile afin de pouvoir induire un mouvement alternatif d'un élément résonant. Un support 36 muni de brides 38 est monté mobile par rapport au plateau 35. Le support 36 peut par exemple être monté mobile en translation selon trois axes ou en rotation, afin de placer séquentiellement les microstructures à tester de façon appropriée sous les faisceaux. Des brides 38 permettent de fixer une tranche de silicium devant être testée. On peut également maintenir la tranche en position au moyen d'un vide créé au niveau du support 36. Le support 36, les générateurs 31, 32 et le détecteur 33 sont disposés à l'intérieur d'une enceinte 34 afin de créer un vide. Un module de commande permet de positionner et de contrôler les faisceaux d'excitation et de détection, de contrôler le niveau du vide ou de déplacer le support 36 à l'intérieur de l'enceinte 34. Le dispositif 3 pourra présenter un sas de chargement robotisé de tranches de silicium dans une réalisation industrielle.

Le dispositif de test 3 comprend avantageusement un dispositif d'imagerie de type électronique à balayage (non illustré) afin d'obtenir une image de la microstructure 1 et ainsi permettre un contrôle visuel pour positionner le faisceau d'excitation sur un emplacement approprié de l'élément 14.

L'application des faisceaux d'excitation et de détection sous vide est souhaitable pour un bon fonctionnement de l'excitation et de la détection. De plus, le vide est favorable à une excitation de l'élément 14, une faible pression environnante facilitant le déplacement de l'élément 14 et permettant d'obtenir un facteur de qualité aussi proche du maximum théorique que possible.

Bien que l'utilisation d'un faisceau d'excitation et d'un faisceau de détection distincts aient été décrite pour réaliser le test, un seul et même faisceau peut être utilisé en présence de conditions favorables. Un faisceau d'électrons secondaires induit par le faisceau d'excitation pourra ainsi être détecté. On pourra effectuer une détection synchrone en fréquence avec le faisceau d'excitation. Le traitement du signal lors de la détection peut alors comprendre la discrimination du signal induit par le faisceau d'excitation par rapport aux variations induites par le mouvement de l'élément 14. Plus le facteur de qualité de l'élément 14 est important, plus l'amplitude du signal induit par son mouvement est aisée à identifier.

Lors de l'application d'un faisceau d'électrons d'excitation, la direction d'émission des électrons secondaires varie avec le mouvement de l'élément 14. Un détecteur peut ainsi déterminer le mouvement de l'élément 14 en fonction de cette variation. Un détecteur peut également déterminer le mouvement de l'élément 14 en fonction d'une alternance entre une réflexion et une diffraction du faisceau d'excitation. La réflexion correspond à une période durant laquelle le faisceau d'excitation est appliqué sur l'élément 14, la diffraction correspondant à une période durant laquelle le faisceau d'excitation est appliqué à côté de l'élément 14.

Un angle de faisceau réduit par rapport au degré de liberté favorise l'excitation mais pénalise la détection. En effet, un faisceau de détection est optimal s'il est orthogonal au degré de liberté observé. Pour un élément 14 se déplaçant dans le plan de la tranche de silicium, un faisceau de détection normal à ce plan est ainsi optimal.

Bien que l'on ait décrit des procédés d'excitation et de mesure basés sur des faisceaux d'électrons, d'autres faisceaux de particules chargées peuvent également être utilisés. Un faisceau d'ions peut également être utilisé. D'autres types de charges ou de particules pourraient permettre de limiter des effets parasites d'un faisceau d'électrons.

Les procédés d'excitation et de test peuvent être mis en oeuvre à la fois dans un processus industriel ou dans des expériences de laboratoires.

## Revendications

1. Procédé d'excitation d'un élément résonant (14) d'une microstructure (1), cet élément étant mobile selon un degré de liberté, le procédé comprenant une étape d'application d'un faisceau de particules chargées (51) sur ladite microstructure (1), le faisceau étant configuré de façon à entraîner l'élément selon un mouvement alternatif selon son degré de liberté.

2. Procédé d'excitation selon la revendication 1, dans lequel le faisceau de particules est appliqué sur ledit élément (14) pour l'entraîner par effet mécanique selon ledit mouvement alternatif .

3. Procédé d'excitation selon la revendication 2, dans lequel le faisceau de particules est appliqué sur ledit élément (14) selon une incidence présentant une composante parallèle audit degré de liberté.

4. Procédé d'excitation selon la revendication 3, dans lequel l'angle du faisceau est inférieur à 45° par rapport audit degré de liberté.

5. Procédé d'excitation selon la revendication 1, dans lequel la microstructure comprend en outre un dispositif d'excitation conducteur, disposé à proximité dudit élément résonant, le faisceau de particules étant appliqué sur le dispositif d'excitation de façon à entraîner l'élément résonant (14) selon ledit mouvement alternatif, par effet capacitif entre l'élément résonant (14) et le dispositif d'excitation.

6. Procédé d'excitation selon la revendication 5, dans lequel le dispositif d'excitation conducteur comprend une électrode d'excitation (13) en regard de l'élément (14) et un organe conducteur (41) connecté électriquement à l'électrode d'excitation (13), le faisceau de particules étant appliqué sur ledit organe conducteur (41).

7. Procédé d'excitation selon la revendication 6, dans lequel le dispositif d'excitation comprend un circuit électrique (4) raccordant l'électrode d'excitation (13) à la masse et présentant une impédance électrique permettant l'entraînement de l'élément résonant (14) à sa fréquence de résonance.

8. Procédé d'excitation selon l'une quelconque des revendications précédentes, dans lequel la microstructure (1) est disposée dans une enceinte (34) sous vide durant l'excitation de l'élément (14).

9. Procédé d'excitation selon l'une quelconque des revendications précédentes, dans lequel ledit faisceau présente des propriétés variables temporellement de façon à entraîner l'élément selon ledit mouvement alternatif.

10. Procédé d'excitation selon la revendication 9, dans lequel les propriétés du faisceau (51) varient temporellement soit en déplaçant le faisceau par rapport à la microstructure de façon à ce qu'elle reçoive alternativement le faisceau de particules soit en maintenant le faisceau fixe par rapport à la microstructure et en appliquant un faisceau d'intensité variable.

11. Procédé d'excitation selon la revendication 9 ou 10, dans lequel les propriétés variables du faisceau comprennent la vitesse des particules chargées, l'angle du faisceau par rapport au degré de liberté ou l'amplitude du faisceau.

12. Procédé d'excitation selon l'une quelconque des revendications 9 à 11, dans lequel les propriétés du faisceau (51) varient temporellement avec une fréquence variable incluse dans une plage de fréquences incluant la fréquence de résonance supposée du mouvement de l'élément résonant (14) selon son degré de liberté.

13. Procédé d'excitation selon l'une quelconque des revendications précédentes, dans lequel une des dimensions dudit élément (14) est submicronique

14. Procédé de test d'un élément d'une microstructure, comprenant l'excitation dudit élément (14) selon le procédé d'excitation de l'une quelconque des revendications précédentes, et comprenant en outre la mesure de la fréquence de résonance dudit élément (14) selon son degré de liberté.

15. Procédé de test selon la revendication 14, dans lequel la mesure de la fréquence de résonance comprend :
- l'application d'un autre faisceau de particules chargées (52) sur ledit élément, lesdits faisceaux (51,52) présentant des angles d'incidence distincts ;
- la détection de particules chargées (53) émises par ledit élément (14) lors de l'application de l'autre faisceau (52).

16. Procédé de test selon la revendication 14 ou 15, dans lequel ladite microstructure est ménagée dans une plaquette incluant plusieurs microstructures similaires et dans lequel plusieurs desdites microstructures sont testées séquentiellement.

17. Procédé de test selon la revendication 16, dans lequel lesdites microstructures sont testées séquentiellement en maintenant ladite plaquette dans une enceinte sous vide (34).

## Claims

1. A method of excitation for a resonant element (14) of a microstructure (1), this element being mobile with a degree of freedom, the method comprising a step of applying a charged particle beam (51) to said microstructure (1), the beam being configured so as to drive the element in an alternating motion along its degree of freedom.

2. The method of excitation according to claim 1, wherein the particle beam is applied to said element (14) so as to drive it by a mechanical effect in said alternating motion.

3. The method of excitation according to claim 2, wherein the particle beam is applied to said element (14) at an incidence having a component parallel to said degree of freedom.

4. The method of excitation according to claim 3, wherein the angle of the beam is less than 45° relative to said degree of freedom.

5. The method of excitation according to claim 1, wherein the microstructure further comprises a conductive excitation device disposed in the vicinity of said resonant element, the particle beam being applied to the excitation device so as to drive the resonant element (14) according to said alternating motion by a capacitive effect between the resonant element (14) and the excitation device.

6. The method of excitation according to claim 5, wherein the conductive excitation device comprises an excitation electrode (13) facing the element (14) and a conductive unit (41) electrically connected to the excitation electrode (13), the particle beam being applied to said conductive unit (41).

7. The method of excitation according to claim 6, wherein the excitation device comprises an electrical circuit (4) connecting the excitation electrode (13) to earth and having an electrical impedance permitting the driving of the resonant element (14) at its resonance frequency.

8. The method of excitation according to any one of the preceding claims, wherein the microstructure (1) is disposed in a vacuum chamber (34) during the excitation of the element (14).

9. The method of excitation according to any one of the preceding claims, wherein said beam has properties variable in time so as to drive the element in said alternating motion.

10. The method of excitation according to claim 9, wherein the properties of the beam (51) vary in time either by displacing the beam relative to the microstructure so that it receives the particle beam alternately, or by keeping the beam fixed relative to the microstructure and applying a beam of variable intensity.

11. The method of excitation according to claim 9 or 10, wherein the variable properties of the beam include the speed of the charged particles, the angle of the beam relative to the degree of freedom or the amplitude of the beam.

12. The method of excitation according to any one of claims 9 to 11, wherein the properties of the beam (51) vary in time with a variable frequency included within a range of frequencies including the assumed resonance frequency of the motion of the resonant element (14) along its degree of freedom.

13. The method of excitation according to any one of the preceding claims, wherein one of the dimensions of said element (14) is submicronic.

14. A method for testing an element of a microstructure comprising the excitation of said element (14) according to the method of excitation of any one of the preceding claims, and further comprising the measurement of the resonance frequency of said element (14) along its degree of freedom.

15. The method for testing according to claim 14, wherein the measurement of the resonance frequency comprises:
- the application of another charged particle beam (52) to said element, said beams (51, 52) having different angles of incidence;
- the detection of the charged particles (53) emitted by said element (14) during the application of the other beam (52).

16. The method for testing according to claim 14 or 15, wherein said microstructure is provided in a wafer including a plurality of similar microstructures and wherein a plurality of said microstructures is tested sequentially.

17. The method for testing according to claim 16, wherein said microstructures are tested sequentially while said wafer is held in a vacuum chamber (34).

## Patentansprüche

1. Verfahren zur Erregung eines Resonanzelements (14) einer Mikrostruktur (1), wobei dieses Element entlang eines Freiheitsgrades beweglich ist, wobei das Verfahren einen Schritt des Aufbringens eines Bündels von geladenen Teilchen (51) auf die Mikrostruktur (1) umfasst, wobei das Bündel derart vorgesehen ist, dass es das Element in einer Wechselbewegung entlang des Freiheitsgrades antreibt.

2. Erregungsverfahren nach Anspruch 1, bei dem das Teilchenbündel auf das Element (14) aufgebracht wird, um es durch mechanische Wirkung in der Wechselbewegung anzutreiben.

3. Erregungsverfahren nach Anspruch 1, bei dem das Teilchenbündel auf das Element (14) entlang eines Einfallswinkels aufgebracht wird, der eine Komponente parallel zum Freiheitsgrad aufweist.

4. Erregungsverfahren nach Anspruch 3, bei dem der Winkel des Bündels kleiner als 45° in Bezug zum Freiheitsgrad ist.

5. Erregungsverfahren nach Anspruch 1, bei dem die Mikrostruktur ferner eine leitende Erregungsvorrichtung umfasst, die in der Nähe des Resonanzelements angeordnet ist, wobei das Teilchenbündel auf die Erregungsvorrichtung aufgebracht wird, um das Resonanzelement (14) in der Wechselbewegung durch kapazitive Wirkung zwischen dem Resonanzelement (14) und der Erregungsvorrichtung anzutreiben.

6. Erregungsverfahren nach Anspruch 5, bei dem die leitende Erregungsvorrichtung eine Erregerelektrode (13) gegenüber dem Element (14) und ein leitendes Element (41) umfasst, das elektrisch an die Erregerelektrode (13) angeschlossen ist, wobei das Teilchenbündel auf das leitende Element (41) aufgebracht wird.

7. Erregungsverfahren nach Anspruch 6, bei dem die Erregungsvorrichtung eine elektrische Schaltung (4) umfasst, die die Erregerelektrode (13) an die Masse anschließt und eine elektrische Impedanz aufweist, die den Antrieb des Resonanzelements (14) mit seiner Resonanzfrequenz ermöglicht.

8. Erregungsverfahren nach einem der vorhergehenden Ansprüche, bei dem die Mikrostruktur (1) in einem Raum (34) unter Vakuum während der Erregung des Elements (14) angeordnet ist.

9. Erregungsverfahren nach einem der vorhergehenden Ansprüche, bei dem das Bündel zeitlich variable Eigenschaften aufweist, um das Element in der Wechselbewegung anzutreiben.

10. Erregungsverfahren nach Anspruch 9, bei dem die Eigenschaften des Bündels (51) zeitlich variieren, wobei entweder das Bündel in Bezug zur Mikrostruktur verschoben wird, so dass sie alternativ das Teilchenbündel aufnimmt, wobei entweder das Bündel fest in Bezug zur Mikrostruktur gehalten oder ein Bündel von variabler Stärke aufgebracht wird.

11. Erregungsverfahren nach Anspruch 9 oder 10, bei dem die variablen Eigenschaften des Bündels die Geschwindigkeit der geladenen Teilchen, den Winkel des Bündels in Bezug zum Freiheitsgrad oder die Amplitude des Bündels umfassen.

12. Erregungsverfahren nach einem der Ansprüche 9 bis 11, bei dem die Eigenschaften des Bündels (51) zeitlich variieren, mit einer variablen Frequenz, die in einen Frequenzbereich eingeschlossen ist, der die angenommene Resonanzfrequenz der Bewegung des Resonanzelements (14) entlang seines Freiheitsgrades einschließt.

13. Erregungsverfahren nach einem der vorhergehenden Ansprüche, bei dem eine der Dimensionen des Elements (14) im Submikronenbereich liegt.

14. Testverfahren eines Elements einer Mikrostruktur, umfassend die Erregung des Elements (14) nach dem Erregungsverfahren eines der vorhergehenden Ansprüche, und umfassend ferner das Messen der Resonanzfrequenz des Elements (14) entlang seines Freiheitsgrades.

15. Testverfahren nach Anspruch 14, bei dem die Messung der Resonanzfrequenz umfasst:
- das Aufbringen eines weiteren Bündels von geladenen Teilchen (52) auf das Element, wobei die Bündel (51, 52) unterschiedliche Einfallswinkel aufweisen;
- die Erfassung von geladenen Teilchen (53), die von dem Element (14) beim Aufbringen des weiteren Bündels (52) entsandt werden.

16. Testverfahren nach Anspruch 14 oder 15, bei dem die Mikrostruktur in einer Platte ausgespart ist, die mehrere ähnliche Mikrostrukturen einschließt, und bei dem mehrere der Mikrostrukturen sequentiell getestet werden.

17. Testverfahren nach Anspruch 16, bei dem die Mikrostrukturen sequentiell getestet werden, wobei die Platte in einem Raum unter Vakuum (34) gehalten wird.
